(19) Europäisches Patentamt European Patent Office Office européen des brevets

(11) EP 4 671 782 A1

(12) EUROPEAN PATENT APPLICATION
published in accordance with Art. 153(4) EPC

(43) Date of publication:
31.12.2025 Bulletin 2026/01

(21) Application number: 23923732.4

(22) Date of filing: 30.10.2023

(51) International Patent Classification (IPC):
G01R 31/367 (2019.01)    G01R 31/385 (2019.01)

(52) Cooperative Patent Classification (CPC):
G01R 31/367; G01R 31/382; G01R 31/385;
G06F 17/10

(86) International application number:
PCT/CN2023/127741

(87) International publication number:
WO 2024/174567 (29.08.2024 Gazette 2024/35)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 21.02.2023 CN 202310189873

(71) Applicant: BYD Company Limited
Shenzhen, Guangdong 518118 (CN)

(72) Inventors:
• FENG, Tianyu
  Shenzhen, Guangdong 518118 (CN)
• ZHU, Tianxiang
  Shenzhen, Guangdong 518118 (CN)
• XIONG, Shi
  Shenzhen, Guangdong 518118 (CN)

(74) Representative: Mathys & Squire
The Shard
32 London Bridge Street
London SE1 9SG (GB)

(54) **METHOD AND APPARATUS FOR CALCULATING REMAINING CHARGING TIME OF BATTERY**

(57) The present invention provides a method and an apparatus for calculating remaining charging time of a battery, and pertains to the field of technologies for calculating remaining charging time of a battery. The method includes: obtaining a calculated remaining charging time value at a current calculation moment in a process of charging a battery, and obtaining an output remaining charging time value at a previous output moment; determining a remaining charging time optimization coefficient based on the calculated remaining charging time value at the current calculation moment and the output remaining charging time value at the previous output moment; and determining an output remaining charging time value at a current output moment based on the output remaining charging time value at the previous output moment, the remaining charging time optimization coefficient, and a time interval between the current calculation moment and the previous output moment. According to the method and the apparatus for calculating remaining charging time of a battery in the present invention, calculated remaining charging time is smoothed and then output, to avoid abrupt changes in the output remaining charging time.

Obtain a calculated remaining charging time value at a current calculation moment in a process of charging a battery, and obtain an output remaining charging time value at a previous output moment — Step 1

Determine a remaining charging time optimization coefficient based on the calculated remaining charging time value at the current calculation moment and the output remaining charging time value at the previous output moment — Step 2

Determine an output remaining charging time value at a current output moment based on the output remaining charging time value at the previous output moment, the remaining charging time optimization coefficient, and a time interval between the current calculation moment and the previous output moment — Step 3

FIG. 1

## Description

### TECHNICAL FIELD

The present invention relates to the field of technologies for calculating remaining charging time of a battery, and in particular, to a method for calculating remaining charging time of a battery and an apparatus for calculating remaining charging time of a battery.

### BACKGROUND

With the development of pure electric and hybrid vehicle technologies, the proportion of pure electric vehicles and hybrid vehicles is gradually increasing. In the process of using the pure electric vehicles and the hybrid vehicles, charging time of batteries is a common concern. Accurate charging time helps users manage their time properly and improve user experience.

However, in existing solutions for estimating charging time of the pure electric vehicles and the hybrid vehicles, remaining charging time is generally estimated based on a current state parameter such as an SOC (state of charge) or a charging current. However, battery temperature and a change in current charge level affect the remaining charging time, and the charging current varies with changes in the battery voltage. If the remaining charging time of the electric vehicle is estimated by using the charging current, estimation accuracy is low, estimation results are inaccurate, and there may be abrupt changes in the remaining charging time of the electric vehicle, which are prone to result in a relatively poor user experience.

### SUMMARY

An objective of embodiments of the present invention is to provide a method and an apparatus for calculating remaining charging time of a battery, to resolve at least the following problems described above: In existing solutions for estimating charging time of pure electric vehicles and hybrid vehicles, remaining charging time is generally estimated based on a current state parameter such as an SOC or a charging current. However, battery temperature and a change in current charge level affect the remaining charging time, and the charging current varies with changes in the battery voltage. If the remaining charging time of the electric vehicle is estimated by using the charging current, estimation accuracy is low, estimation results are inaccurate, and there may be abrupt changes in the remaining charging time of the electric vehicle, which are prone to result in a relatively poor user experience.

To achieve the foregoing objective, according to a first aspect of the present invention, a method for calculating remaining charging time of a battery is provided. The method includes:

obtaining a calculated remaining charging time value at a current calculation moment in a process of charging a battery, and obtaining an output remaining charging time value at a previous output moment;

determining a remaining charging time optimization coefficient based on the calculated remaining charging time value at the current calculation moment and the output remaining charging time value at the previous output moment; and

determining an output remaining charging time value at a current output moment based on the output remaining charging time value at the previous output moment, the remaining charging time optimization coefficient, and a time interval between the current calculation moment and the previous output moment.

According to a second aspect of the present invention, an apparatus for calculating remaining charging time of a battery is provided. The apparatus includes:

a data obtaining module, configured to: obtain a calculated remaining charging time value at a current calculation moment in a process of charging a battery, and obtain an output remaining charging time value at a previous output moment;

an optimization coefficient determining module, configured to determine a remaining charging time optimization coefficient based on the calculated remaining charging time value at the current calculation moment and the output remaining charging time value at the previous output moment; and

a remaining charging time determining module, configured to determine an output remaining charging time value at a current output moment based on the output remaining charging time value at the previous output moment, the remaining charging time optimization coefficient, and a time interval between the current calculation moment and the previous output moment.

According to a third aspect of the present invention, an electronic device is provided and includes a memory, a processor, and a computer program that is stored in the memory and that is capable of running on the processor. When the processor executes the computer program, the foregoing method for calculating remaining charging time of a battery is implemented.

According to another aspect, the present invention provides a readable storage medium. The readable storage medium stores instructions, and the instructions are used to enable a machine to perform the foregoing method for calculating remaining charging time of a battery.

In the technical solutions, the remaining charging time optimization coefficient is determined by using the calculated remaining charging time value at the current calculation moment and the output remaining charging time value at the previous output moment, and the output remaining charging time value at the current output moment is optimized by using the remaining charging time optimization coefficient, so that high estimation accuracy is achieved. Calculated remaining charging time is smoothed, to avoid abrupt data changes in the output remaining charging time, thereby improving user experience. In addition, compared with a smoothing method in the conventional technology, the solutions are more applicable to real-time stream data, do not require filtering or another method, do not require a complex calculation process, and have a simple calculation method.

Other features and advantages of the embodiments of the present invention are described in detail in the subsequent part of DESCRIPTION OF EMBODIMENTS.

## BRIEF DESCRIPTION OF DRAWINGS

The accompanying drawings are used to provide a further understanding of the embodiments of the present invention, constitute a part of this specification, and are used together with the following specific embodiments to explain the embodiments of the present invention, but do not constitute a limitation on the embodiments of the present invention. In the accompanying drawings:

FIG. 1 is a flowchart of a method for calculating remaining charging time of a battery according to an embodiment of the present invention;

FIG. 2 is a flowchart of determining a remaining charging time optimization coefficient according to an embodiment of the present invention;

FIG. 3 is a flowchart of another method for calculating remaining charging time of a battery according to an embodiment of the present invention;

FIG. 4 is a schematic structural diagram of an apparatus for calculating remaining charging time of a battery according to an embodiment of the present invention; and

FIG. 5 is a schematic diagram of comparison between remaining charging time before optimization and remaining charging time after optimization according to an embodiment of the present invention.

## DESCRIPTION OF EMBODIMENTS

The following describes specific embodiments of the present invention in detail with reference to the accompanying drawings. It will be understood that the specific embodiments described herein are merely used to describe and explain the present invention, and are not intended to limit the present invention.

### Embodiment 1

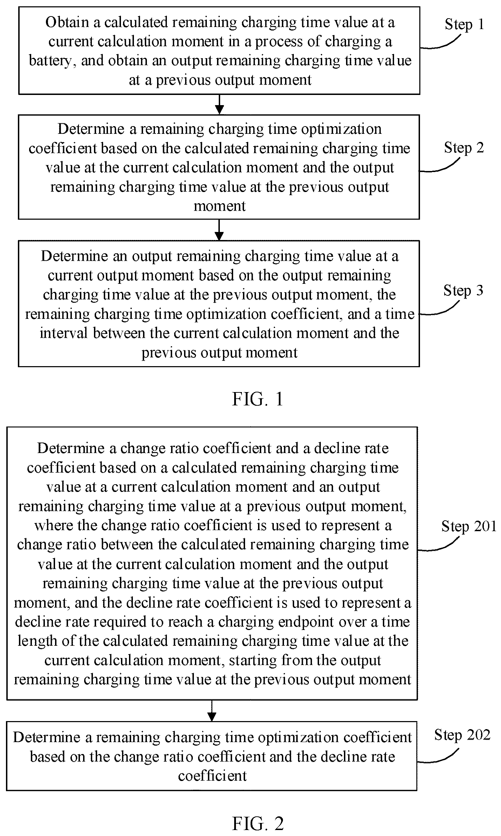

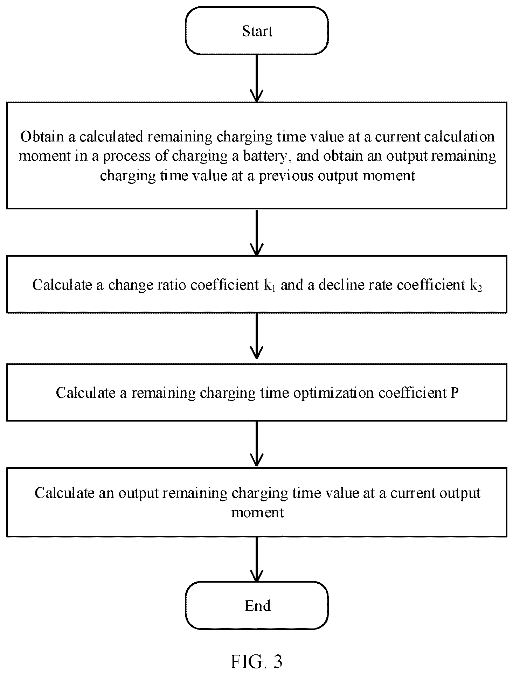

As shown in FIG. 1 to FIG. 3, this embodiment of the present invention provides a method for calculating remaining charging time of a battery. The method includes the following steps:

Step 1: Obtain a calculated remaining charging time value at a current calculation moment in a process of charging a battery, and obtain an output remaining charging time value at a previous output moment.

In this embodiment, the calculated remaining charging time value at the current calculation moment may be calculated by using existing methods for estimating remaining charging time of a battery based on a current state parameter such as an SOC or a charging current. These methods are conventional technologies known to a person skilled in the art in the field of pure electric vehicles and hybrid vehicles. Details are not described herein again.

Step 2: Determine a remaining charging time optimization coefficient based on the calculated remaining charging time value at the current calculation moment and the output remaining charging time value at the previous output moment.

In this embodiment, the remaining charging time optimization coefficient may be determined by performing the following steps 201 and 202.

Step 201: Determine a change ratio coefficient and a decline rate coefficient based on the calculated remaining charging time value at the current calculation moment and the output remaining charging time value at the previous output moment, where the change ratio coefficient is used to represent a change ratio between the calculated remaining charging time value at the current calculation moment and the output remaining charging time value at the previous output moment, and the decline rate coefficient is used to represent a decline rate required to reach a charging endpoint over a time length of the calculated remaining charging time value at the current calculation moment, starting from the output remaining charging time value at the previous output moment.

Specifically, the change ratio coefficient is calculated by using the following calculation formula:

$$\begin{cases} K_1 = \dfrac{T_{Ouput\ n-1} - T_{Calculation\ n}}{t_n - t_m} & T_{Ouput\ n-1} > T_{Calculation\ n} \\[4mm] K_1 = \dfrac{t_m - t_n}{T_{Ouput\ n-1} - T_{Calculation\ n} - A_0(t_n - t_m)} & T_{Ouput\ n-1} < T_{Calculation\ n} \end{cases}$$

Herein, $K_1$ is the change ratio coefficient, and remains a value greater than 0; $T_{Ouput\ n-1}$ is the output remaining charging time value at the previous output moment; $T_{Calculation\ n}$ is the calculated remaining charging time value at the current calculation moment; $t_n$ is the current calculation moment; $t_m$ is a previous calculation moment; and both $t_n - t_m$ and $t_m - t_n$ are time intervals between the current calculation moment and a previous moment for calculating remaining charging time. The previous moment for calculating remaining charging time is the previous calculation moment, and a time interval between adjacent calculation moments is a specified value. Therefore, both the current calculation moment and the previous calculation moment may be considered as known values. When the change ratio coefficient is calculated by using the foregoing formula, both $t_n - t_m$ and $t_m - t_n$ are known constants. Herein, $A_0$ is a preset reference value, and may be adjusted based on an actual situation.

In this embodiment, the change ratio coefficient is calculated by using the foregoing formulas based on the output remaining charging time value at the previous output moment and the calculated remaining charging time value at the current calculation moment. In this way, different change ratio coefficients can be used for different cases, to improve a subsequent smoothing effect. That both $t_n - t_m$ and $t_m - t_n$ are time intervals between the current calculation moment and a previous moment for calculating remaining charging time may be understood as that there is a time interval between a moment for calculating remaining charging time and a moment for outputting remaining charging time. In this case, the moment for calculating remaining charging time and the moment for outputting remaining charging time do not overlap.

The decline rate coefficient is calculated by using the following calculation formula:

$$K_2 = \frac{T_{Ouput\ n-1} - (t_n - t_{n-1})}{T_{Calculation\ n}}$$

Herein, $K_2$ is the decline rate coefficient; $T_{Ouput\ n-1}$ is the output remaining charging time value at the previous output moment; $T_{Calculation\ n}$ is the calculated remaining charging time value at the current calculation moment; $t_n$ is the current calculation moment; $t_{n-1}$ is the previous output moment; and $t_n - t_{n-1}$ is a time interval between the current calculation moment and the previous output moment.

More specifically, the decline rate coefficient $K_2$ means a decline rate required to reach the charging endpoint over a current estimated time length, starting from the output remaining charging time value at the previous output moment.

Step 202: Determine the remaining charging time optimization coefficient based on the change ratio coefficient and the decline rate coefficient.

Specifically, the remaining charging time optimization coefficient is calculated by using the following calculation formula:

$$P = A_1 \cdot K_1 + A_2 \cdot K_2 + A_3$$

Herein, P is the remaining charging time optimization coefficient; $K_1$ is the change ratio coefficient; $K_2$ is the decline rate coefficient; and $A_1$, $A_2$, and $A_3$ are constants.

In this embodiment, $A_1$, $A_2$, and $A_3$ are all constants, and are determined based on historical data or an actual situation. Through adjustment of specific values of $A_1$, $A_2$, and $A_3$ in different cases, a specific value of the remaining charging time optimization coefficient may be changed, and a final smoothing effect of an output remaining charging time value at a current output moment may be optimized.

Step 3: Determine the output remaining charging time value at the current output moment based on the output remaining charging time value at the previous output moment, the remaining charging time optimization coefficient, and the time interval between the current calculation moment and the previous output moment.

The output remaining charging time value at the current output moment may be calculated by using the following calculation formula:

$$T_{Ouput\,n} = T_{Ouput\,n-1} - P \cdot (t_n - t_{n-1})$$

Herein, $T_{Output\,n}$ is the output remaining charging time value at the current output moment; $T_{Output\,n-1}$ is the output remaining charging time value at the previous output moment; $P$ is the remaining charging time optimization coefficient; $t_n$ is the current calculation moment; and $t_{n-1}$ is the previous output moment.

In this embodiment, the output remaining charging time value at the current output moment is the output remaining charging time value at the previous output moment minus a product, and the product is a product of the remaining charging time optimization coefficient P and the time interval. Herein, $t_n$ is the current calculation moment, $t_{n-1}$ is the previous output moment, and $t_n$ - $t_{n-1}$ is the time interval between the current calculation moment and the previous output moment, may be 1s, 5s, or the like, and may be set based on a data sampling time interval in an actual situation.

**Embodiment 2**

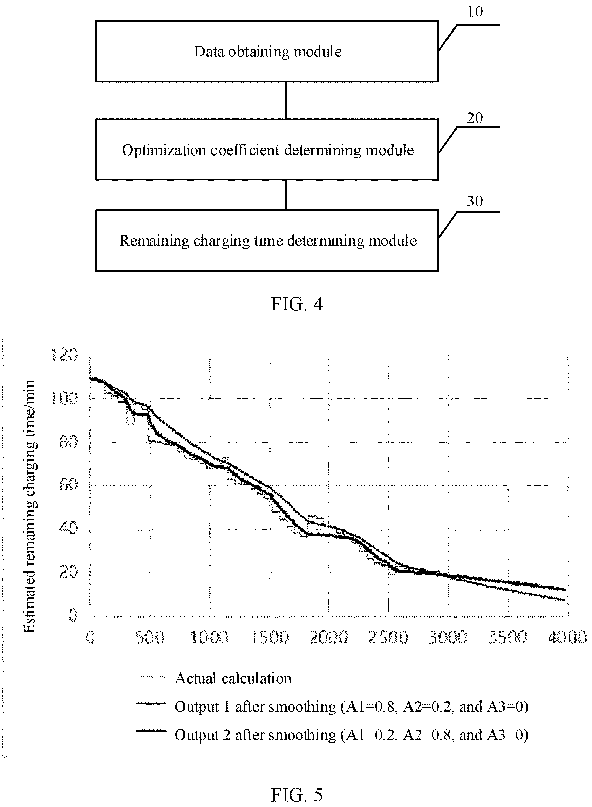

As shown in FIG. 4, this embodiment of the present invention provides an apparatus for calculating remaining charging time of a battery. The apparatus includes:

a data obtaining module 10, configured to: obtain a calculated remaining charging time value at a current calculation moment in a process of charging a battery, and obtain an output remaining charging time value at a previous output moment;
an optimization coefficient determining module 20, configured to determine a remaining charging time optimization coefficient based on the calculated remaining charging time value at the current calculation moment and the output remaining charging time value at the previous output moment; and
a remaining charging time determining module 30, configured to determine an output remaining charging time value at a current output moment based on the output remaining charging time value at the previous output moment, the remaining charging time optimization coefficient, and a time interval between the current calculation moment and the previous output moment.

Specifically, the optimization coefficient determining module 20 includes:

an intermediate coefficient determining unit, configured to determine a change ratio coefficient and a decline rate coefficient based on the calculated remaining charging time value at the current calculation moment and the output remaining charging time value at the previous output moment, where the change ratio coefficient is used to represent a change ratio between the calculated remaining charging time value at the current calculation moment and the output remaining charging time value at the previous output moment, and the decline rate coefficient is used to represent a decline rate required to reach a charging endpoint over a time length of the calculated remaining charging time value at the current calculation moment, starting from the output remaining charging time value at the previous output moment; and
an optimization coefficient output unit, configured to determine the remaining charging time optimization coefficient based on the change ratio coefficient and the decline rate coefficient.

**Embodiment 3**

This embodiment of the present invention provides an electronic device, including a memory, a processor, and a computer program that is stored in the memory and that is capable of running on the processor. When the processor executes the computer program, the foregoing method for calculating remaining charging time of a battery is implemented.

**Embodiment 4**

This embodiment of the present invention provides a readable storage medium. The readable storage medium stores instructions, and the instructions are used to enable a machine to perform the foregoing method for calculating remaining charging time of a battery.

**Embodiment 5**

In this embodiment, for a process of charging a vehicle battery, first, remaining charging time of the battery is estimated based on a current state parameter such as an SOC or a charging current, to obtain a calculated remaining charging time value at a current calculation moment, and smoothing is performed by using the foregoing method for calculating remaining charging time of a battery in the solutions. In a process of calculating a charging time optimization coefficient, two different sets of values of $A_1$, $A_2$, and $A_3$ are set. In a first set, $A_1 = 0.8$, $A_2 = 0.2$, and $A_3 = 0$ are used, and in a second set, $A_1 = 0.2$, $A_2 = 0.8$, and $A_3 = 0$ are used. Three remaining charging time curves are plotted by using a sampling moment as a horizontal coordinate and remaining charging time as a vertical coordinate, to obtain a schematic diagram of comparison between remaining charging time before optimization and remaining charging time after optimization, as shown in FIG. 5. It will be understood, through comparison, that after smoothing is performed by using the foregoing method for calculating remaining charging time of a battery in the solutions, the curve is smoother. Compared with a result obtained without optimization processing, a curve formed by an output remaining charging time value at a current output moment is smoother, so that abrupt data changes in an output remaining charging time can be avoided, thereby improving user experience.

A person skilled in the art will understand that all or some of the steps in the methods in the foregoing embodiments may be implemented by a program instructing related hardware. The program is stored in a storage medium and includes several instructions for instructing a single-chip microcomputer, a chip, or a processor (processor) to perform all or some of the steps in the methods in the embodiments of the present invention. The storage medium includes any medium that can store program code, for example, a USB flash drive, a removable hard disk, a read-only memory (ROM, Read-Only Memory), a random access memory (RAM, Random Access Memory), a magnetic disk, or an optical disc.

Optional embodiments of the present invention are described above in detail with reference to the accompanying drawings. However, the embodiments of the present invention are not limited to specific details in the foregoing embodiments. Within the technical concept scope of the embodiments of the present invention, a plurality of simple variations can be made to the technical solutions in the embodiments of the present invention, and all of these simple variations fall within the protection scope of the embodiments of the present invention. In addition, it should be noted that the specific technical features described in the foregoing specific embodiments may be combined in any suitable manner when there is no conflict. To avoid unnecessary repetition, various possible combination manners are not further described in the embodiments of the present invention.

In addition, various different embodiments of the present invention may be randomly combined. Provided that the combination does not depart from the idea of the embodiments of the present invention, the combination shall also be considered as content disclosed in the embodiments of the present invention.

**Claims**

1.   A method for calculating remaining charging time of a battery, comprising:

obtaining a calculated remaining charging time value at a current calculation moment in a process of charging a battery, and obtaining an output remaining charging time value at a previous output moment;
determining a remaining charging time optimization coefficient based on the calculated remaining charging time value at the current calculation moment and the output remaining charging time value at the previous output moment; and
determining an output remaining charging time value at a current output moment based on the output remaining charging time value at the previous output moment, the remaining charging time optimization coefficient, and a time interval between the current calculation moment and the previous output moment.

2.   The method for calculating remaining charging time of the battery according to claim 1, wherein determining the remaining charging time optimization coefficient based on the calculated remaining charging time value at the current calculation moment and the output remaining charging time value at the previous output moment comprises:

determining a change ratio coefficient and a decline rate coefficient based on the calculated remaining charging time value at the current calculation moment and the output remaining charging time value at the previous output moment, wherein the change ratio coefficient is used to represent a change ratio between the calculated remaining charging time value at the current calculation moment and the output remaining charging time value at the previous output moment, and the decline rate coefficient is used to represent a decline rate required to reach a charging endpoint over a time length of the calculated remaining charging time value at the current calculation moment, starting from the output remaining charging time value at the previous output moment; and determining the remaining charging time optimization coefficient based on the change ratio coefficient and the decline rate coefficient.

3. The method for calculating remaining charging time of the battery according to claim 2, wherein determining the change ratio coefficient based on the calculated remaining charging time value at the current calculation moment and the output remaining charging time value at the previous output moment comprises:
calculating the change ratio coefficient by using the following calculation formula:

$$\begin{cases} K_1 = \dfrac{T_{Ouput\ n-1} - T_{Calculation\ n}}{t_n - t_m} & T_{Ouput\ n-1} > T_{Calculation\ n} \\[4mm] K_1 = \dfrac{t_m - t_n}{T_{Ouput\ n-1} - T_{Calculation\ n} - A_0(t_n - t_m)} & T_{Ouput\ n-1} < T_{Calculation\ n} \end{cases},$$

wherein
$K_1$ is the change ratio coefficient; $T_{Output\ n-1}$ is the output remaining charging time value at the previous output moment; $T_{Calculation\ n}$ is the calculated remaining charging time value at the current calculation moment; $t_n$ is the current calculation moment; $t_m$ is a previous calculation moment; and $A_0$ is a preset reference value.

4. The method for calculating remaining charging time of the battery according to claim 2 or 3, wherein determining the decline rate coefficient based on the calculated remaining charging time value at the current calculation moment and the output remaining charging time value at the previous output moment comprises:
calculating the decline rate coefficient by using the following calculation formula:

$$K_2 = \dfrac{T_{Ouput\ n-1} - (t_n - t_{n-1})}{T_{Calculation\ n}},$$

wherein
$K_2$ is the decline rate coefficient; $T_{Output\ n-1}$ is the output remaining charging time value at the previous output moment; $T_{Calculation\ n}$ is the calculated remaining charging time value at the current calculation moment; $t_n$ is the current calculation moment; and $t_{n-1}$ is the previous output moment.

5. The method for calculating remaining charging time of the battery according to any one of claims 2 to 4, wherein determining the remaining charging time optimization coefficient based on the change ratio coefficient and the decline rate coefficient comprises:

$$P = A_1 \cdot K_1 + A_2 \cdot K_2 + A_3,$$

wherein
$P$ is the remaining charging time optimization coefficient; $K_1$ is the change ratio coefficient; $K_2$ is the decline rate coefficient; and $A_1$, $A_2$, and $A_3$ are constants.

6. The method for calculating remaining charging time of the battery according to any one of claims 1 to 5, wherein determining the output remaining charging time value at the current output moment based on the output remaining charging time value at the previous output moment, the remaining charging time optimization coefficient, and the time interval between the current calculation moment and the previous output moment comprises:

$$T_{Ouput\ n} = T_{Ouput\ n-1} - P \cdot (t_n - t_{n-1}),$$

wherein
$T_{Output\ n}$ is the output remaining charging time value at the current output moment; $T_{Output\ n-1}$ is the output remaining charging time value at the previous output moment; $P$ is the remaining charging time optimization coefficient; $t_n$ is the current calculation moment; and $t_{n-1}$ is the previous output moment.

7.  An apparatus for calculating remaining charging time of a battery, wherein the apparatus comprises:

    a data obtaining module, configured to obtain a calculated remaining charging time value at a current calculation moment in a process of charging a battery, and obtain an output remaining charging time value at a previous output moment;
    an optimization coefficient determining module, configured to determine a remaining charging time optimization coefficient based on the calculated remaining charging time value at the current calculation moment and the output remaining charging time value at the previous output moment; and
    a remaining charging time determining module, configured to determine an output remaining charging time value at a current output moment based on the output remaining charging time value at the previous output moment, the remaining charging time optimization coefficient, and a time interval between the current calculation moment and the previous output moment.

8.  The apparatus for calculating remaining charging time of a battery according to claim 7, wherein the optimization coefficient determining module comprises:

    an intermediate coefficient determining unit, configured to determine a change ratio coefficient and a decline rate coefficient based on the calculated remaining charging time value at the current calculation moment and the output remaining charging time value at the previous output moment, wherein the change ratio coefficient is used to represent a change ratio between the calculated remaining charging time value at the current calculation moment and the output remaining charging time value at the previous output moment, and the decline rate coefficient is used to represent a decline rate required to reach a charging endpoint over a time length of the calculated remaining charging time value at the current calculation moment, starting from the output remaining charging time value at the previous output moment; and
    an optimization coefficient output unit, configured to determine the remaining charging time optimization coefficient based on the change ratio coefficient and the decline rate coefficient.

9.  An electronic device, comprising a memory, a processor, and a computer program that is stored in the memory and that is capable of running on the processor, wherein when the processor executes the computer program, the method for calculating remaining charging time of a battery according to any one of claims 1 to 8 is implemented.

10. A readable storage medium, wherein the readable storage medium stores instructions, and the instructions are used to enable a machine to perform the method for calculating remaining charging time of a battery according to any one of claims 1 to 8.

Obtain a calculated remaining charging time value at a current calculation moment in a process of charging a battery, and obtain an output remaining charging time value at a previous output moment

Step 1

Determine a remaining charging time optimization coefficient based on the calculated remaining charging time value at the current calculation moment and the output remaining charging time value at the previous output moment

Step 2

Determine an output remaining charging time value at a current output moment based on the output remaining charging time value at the previous output moment, the remaining charging time optimization coefficient, and a time interval between the current calculation moment and the previous output moment

Step 3

FIG. 1

Determine a change ratio coefficient and a decline rate coefficient based on a calculated remaining charging time value at a current calculation moment and an output remaining charging time value at a previous output moment, where the change ratio coefficient is used to represent a change ratio between the calculated remaining charging time value at the current calculation moment and the output remaining charging time value at the previous output moment, and the decline rate coefficient is used to represent a decline rate required to reach a charging endpoint over a time length of the calculated remaining charging time value at the current calculation moment, starting from the output remaining charging time value at the previous output moment

Step 201

Determine a remaining charging time optimization coefficient based on the change ratio coefficient and the decline rate coefficient

Step 202

FIG. 2

```
                          ┌──────────────┐
                          │    Start     │
                          └──────┬───────┘
                                 │
                                 ▼
┌────────────────────────────────────────────────────────────────────┐
│                                                                      │
│  Obtain a calculated remaining charging time value at a current      │
│  calculation moment in a process of charging a battery, and obtain    │
│  an output remaining charging time value at a previous output moment  │
│                                                                      │
└────────────────────────────────┬───────────────────────────────────┘
                                 │
                                 ▼
┌────────────────────────────────────────────────────────────────────┐
│                                                                      │
│  Calculate a change ratio coefficient k₁ and a decline rate           │
│  coefficient k₂                                                       │
│                                                                      │
└────────────────────────────────┬───────────────────────────────────┘
                                 │
                                 ▼
┌────────────────────────────────────────────────────────────────────┐
│                                                                      │
│  Calculate a remaining charging time optimization coefficient P       │
│                                                                      │
└────────────────────────────────┬───────────────────────────────────┘
                                 │
                                 ▼
┌────────────────────────────────────────────────────────────────────┐
│                                                                      │
│  Calculate an output remaining charging time value at a current       │
│  output moment                                                        │
│                                                                      │
└────────────────────────────────┬───────────────────────────────────┘
                                 │
                                 ▼
                          ┌──────────────┐
                          │     End      │
                          └──────────────┘
```

Obtain a calculated remaining charging time value at a current calculation moment in a process of charging a battery, and obtain an output remaining charging time value at a previous output moment

Calculate a change ratio coefficient $k_1$ and a decline rate coefficient $k_2$

Calculate a remaining charging time optimization coefficient P

Calculate an output remaining charging time value at a current output moment

FIG. 3

FIG. 4

········· Actual calculation

——— Output 1 after smoothing (A1=0.8, A2=0.2, and A3=0)

——— Output 2 after smoothing (A1=0.2, A2=0.8, and A3=0)

FIG. 5

## INTERNATIONAL SEARCH REPORT

| International application No. |
| --- |
| **PCT/CN2023/127741** |

### A. CLASSIFICATION OF SUBJECT MATTER

G01R31/367(2019.01)i; G01R31/385(2019.01)i

According to International Patent Classification (IPC) or to both national classification and IPC

### B. FIELDS SEARCHED

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNTXT, CNABS, CNKI, ENTXTC, VEN: 电池, 剩余, 充电, 时间, 时长, 上一, 时刻, 前一, 跳变, BATTERY, CHARGE, REMAIN, TIME, PREVIOUS

### C. DOCUMENTS CONSIDERED TO BE RELEVANT

| Category* | Citation of document, with indication, where appropriate, of the relevant passages | Relevant to claim No. |
| --- | --- | --- |
| X | WO 2023273911 A1 (ZHEJIANG GEELY HOLDING GROUP CO., LTD. et al.) 05 January 2023 (2023-01-05) description, paragraphs 45-141, and figure 1 | 1, 6, 7, 9-10 |
| X | CN 113504479 A (ZHEJIANG GEELY HOLDING GROUP CO., LTD. et al.) 15 October 2021 (2021-10-15) description, paragraphs 58-109, and figures 1-2 | 1, 6, 7, 9-10 |
| A | CN 106597307 A (DONGGUAN NVT TECHNOLOGY CO., LTD.) 26 April 2017 (2017-04-26) entire document | 1-10 |
| A | CN 111806296 A (HANTENG AUTOMOBILE CO., LTD.) 23 October 2020 (2020-10-23) entire document | 1-10 |
| A | CN 112035777 A (SVOLT ENERGY TECHNOLOGY CO., LTD.) 04 December 2020 (2020-12-04) entire document | 1-10 |

☑ Further documents are listed in the continuation of Box C.   ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **19 January 2024** | **01 February 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**EP 4 671 782 A1**

## INTERNATIONAL SEARCH REPORT

International application No.

**PCT/CN2023/127741**

### C. DOCUMENTS CONSIDERED TO BE RELEVANT

| Category* | Citation of document, with indication, where appropriate, of the relevant passages | Relevant to claim No. |
|---|---|---|
| A | CN 112172592 A (ANHUI JIANGHUAI AUTOMOBILE GROUP CO., LTD.) 05 January 2021 (2021-01-05)<br>entire document | 1-10 |
| A | CN 113238153 A (SVOLT ENERGY TECHNOLOGY CO., LTD.) 10 August 2021 (2021-08-10)<br>entire document | 1-10 |
| A | JP 2018014817 A (TOYOTA MOTOR CORP.) 25 January 2018 (2018-01-25)<br>entire document | 1-10 |
| A | JP H1189105 A (NISSAN MOTOR CO., LTD.) 30 March 1999 (1999-03-30)<br>entire document | 1-10 |
| A | US 5615129 A (GENERAL SIGNAL POWER SYSTEMS, INC.) 25 March 1997 (1997-03-25)<br>entire document | 1-10 |

Form PCT/ISA/210 (second sheet) (July 2022)

13

## INTERNATIONAL SEARCH REPORT
### Information on patent family members

| International application No. |
|---|
| **PCT/CN2023/127741** |

| Patent document cited in search report | | | Publication date (day/month/year) | Patent family member(s) | | | Publication date (day/month/year) |
|---|---|---|---|---|---|---|---|
| WO | 2023273911 | A1 | 05 January 2023 | None | | | |
| CN | 113504479 | A | 15 October 2021 | None | | | |
| CN | 106597307 | A | 26 April 2017 | None | | | |
| CN | 111806296 | A | 23 October 2020 | None | | | |
| CN | 112035777 | A | 04 December 2020 | None | | | |
| CN | 112172592 | A | 05 January 2021 | None | | | |
| CN | 113238153 | A | 10 August 2021 | None | | | |
| JP | 2018014817 | A | 25 January 2018 | JP | 6680123 | B2 | 15 April 2020 |
| JP | H1189105 | A | 30 March 1999 | JP | 3428389 | B2 | 22 July 2003 |
| US | 5615129 | A | 25 March 1997 | None | | | |

Form PCT/ISA/210 (patent family annex) (July 2022)